# EUROPEAN PATENT APPLICATION

(11) **EP 4 799 837 A1**
(43) Date of publication of application: **02.09.2026**
(21) Application number: 26160577.8
(22) Date of filing: 25.02.2026
(51) Int. Cl.: B60K 1/00

(54) **VEHICLE ON-BOARD DEVICE MOUNTING STRUCTURE**

(30) Priority: 28.02.2025 JP 2025031989
(71) Applicant: Toyota Jidosha Kabushiki Kaisha, Toyota-shi, Aichi-ken 471-8571 (JP)
(72) Inventor: SUGIYAMA, Masataka, TOYOTA-SHI, AICHI-KEN, 471-8571 (JP); TAKADA, Norifumi, TOYOTA-SHI, AICHI-KEN, 471-8571 (JP); SEGAWA, Taku, TOYOTA-SHI, AICHI-KEN, 471-8571 (JP); OKAYA, Shingo, TOYOTA-SHI, AICHI-KEN, 471-8571 (JP)
(74) Representative: Cabinet Beau de Loménie

(57) **Abstract**

A rear differential splits drive power transmitted from a rear propeller shaft between two rear drive shafts. A second motor-generator applies the drive power to the two rear drive shafts via the rear differential. The rear differential includes a rear differential ring gear and a rear differential case. A second inverter and the rear differential ring gear overlap with each other when viewed in an axial direction of the rear drive shafts. The second inverter and the rear differential ring gear do not overlap with each other when viewed in an up-down direction of the vehicle. The second inverter and the rear differential case overlap with each other when viewed in the up-down direction.

## Description

### BACKGROUND

### 1. Field

The present disclosure relates to a vehicle on-board device mounting structure.

### 2. Description of Related Art

JP2005-231526A discloses a vehicle including an engine, a propeller shaft, a motor, a differential device, and two rear wheel drive shafts. The engine is disposed in a front portion of the vehicle. The motor and the differential device are disposed in a rear portion of the vehicle. The propeller shaft transmits drive power output from the engine to the differential device. The motor outputs drive power to the differential device. The differential device distributes the drive power transmitted from the propeller shaft and the drive power input from the motor to the two rear wheel drive shafts. The motor and the differential device are accommodated in a differential carrier.

An inverter that performs power conversion between a battery and the motor may be disposed in proximity to the motor. In such cases, depending on the vehicle on-board device mounting structure, the vertical dimension of a unit including the motor, the inverter, and the differential device may increase. An increase in the vertical dimension of the unit may impair the installability of the unit in the vehicle.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a vehicle on-board device mounting structure for a vehicle is provided. The vehicle includes a differential device that splits drive power transmitted from a propeller shaft between two drive shafts, a motor that applies the drive power to the two drive shafts via the differential device, and an inverter that performs power conversion between a battery cell accommodated in a battery pack and the motor. The differential device includes a differential case and a ring gear. The differential case accommodates two side gears respectively coupled to the two drive shafts, and a differential pinion that meshes with both of the two side gears. The ring gear is provided on an outer periphery of the differential case and receiving the drive power transmitted from the propeller shaft and the motor. The vehicle on-board device mounting structure is configured such that the inverter and the ring gear overlap with each other when viewed in an axial direction of the drive shaft, the inverter and the ring gear do not overlap with each other when viewed in an up-down direction of the vehicle, and the inverter and the differential case overlap with each other when viewed in the up-down direction.

Other features and aspects will be apparent from the following detailed description, the drawings, and the claims.

### BRIEF DESCRIPTION OF THE DRAWINGS

Fig. 1 is a schematic diagram showing a configuration of a drivetrain and an electrical system of an electric vehicle according to an embodiment.
Fig. 2 is a schematic diagram showing a vehicle on-board device mounting structure, in which the driving device shown in Fig. 1 is viewed from above.
Fig. 3 is a schematic diagram of the vehicle on-board device mounting structure inside the driving device shown in Fig. 1.
Fig. 4 is a cross-sectional view taken along line 4-4 of Fig. 2.

Throughout the drawings and the detailed description, the same reference numerals refer to the same elements. The drawings may not be to scale, and the relative size, proportions, and depiction of elements in the drawings may be exaggerated for clarity, illustration, and convenience.

### DETAILED DESCRIPTION

This description provides a comprehensive understanding of the methods, apparatuses, and/or systems described. Modifications and equivalents of the methods, apparatuses, and/or systems described are apparent to one of ordinary skill in the art. Sequences of operations are exemplary, and may be changed as apparent to one of ordinary skill in the art, with the exception of operations necessarily occurring in a certain order. Descriptions of functions and constructions that are well known to one of ordinary skill in the art may be omitted.

Exemplary embodiments may have different forms, and are not limited to the examples described. However, the examples described are thorough and complete, and convey the full scope of the disclosure to one of ordinary skill in the art.

In this specification, "at least one of A and B" should be understood to mean "only A, only B, or both A and B."

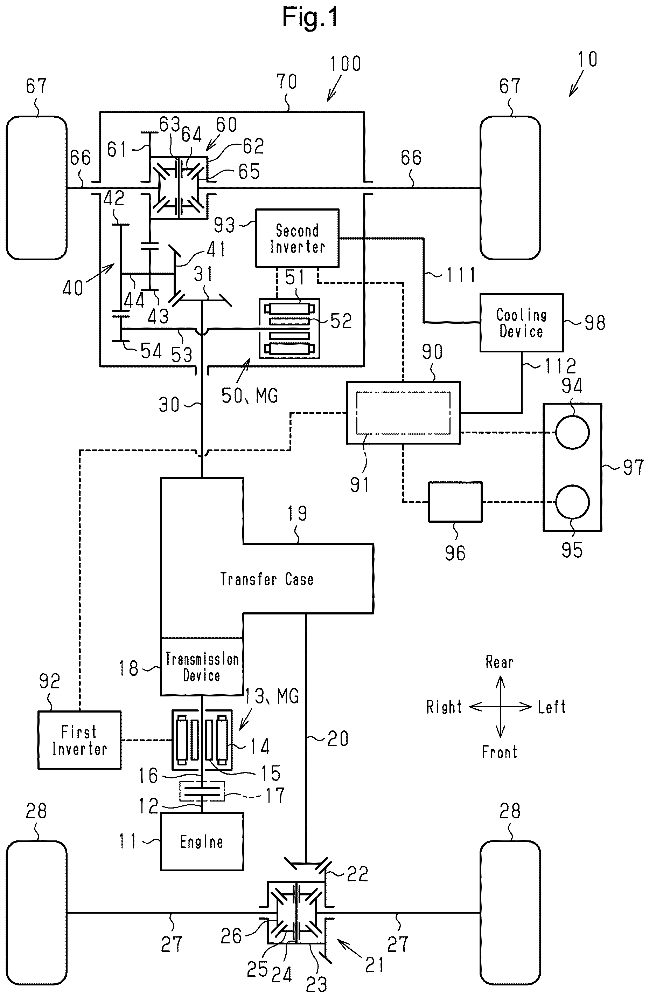

A vehicle on-board device mounting structure according to an embodiment will now be described with reference to Figs. 1 to 4. In the following description, the frontward, rearward, leftward, rightward, upward, and downward directions are defined with reference to the forward traveling direction of the vehicle. The left-right direction corresponds to the vehicle width direction.

The up-down direction is a direction of a vertical line, that is, a height direction. Viewing in the up-down direction refers to viewing from above or viewing from below. A view in the horizontal direction refers to a view from a direction parallel to a horizontal plane perpendicular to the up-down direction.

Fig. 1 schematically shows a configuration of a drivetrain and an electrical system of an electric vehicle 10. Broken lines shown in Fig. 1 indicate electrical connections.

Fig. 1 does not faithfully show the actual relative placement of a rear propeller shaft 30, a hypoid pinion 31, a second motor-generator 50, a speed reduction mechanism 40, and a rear differential 60, which form part of the drivetrain of the electric vehicle 10. Fig. 1 also does not faithfully show the actual relative placement of a battery pack 90, a first inverter 92, a second inverter 93, a first charging port 94, a second charging port 95, a vehicle on-board charger 96, and a charging port assembly 97, which form part of the electrical system of the electric vehicle 10.

As shown in Fig. 1, the electric vehicle 10 includes an engine 11 as a power source, a first motor-generator 13, and the second motor-generator 50. The engine 11 is a power source provided near front wheels 28, and is a known internal combustion engine. The electric vehicle 10 includes a pair of left and right front wheels 28 and a pair of left and right rear wheels 67. The rear wheels 67 serve as primary drive wheels that are driven during both two-wheel-drive operation and four-wheel-drive operation. The front wheels 28 serve as non-driven wheels during two-wheel-drive operation and as auxiliary drive wheels during four-wheel-drive operation. The electric vehicle 10 is a four-wheel-drive vehicle based on a front-engine, rear-drive (FR) layout.

### Electrical System of the Electric Vehicle 10

The electric vehicle 10 includes the battery pack 90. The battery pack 90 accommodates multiple battery cells 91 therein. In Fig. 1, the battery cells 91, which are tightly packed within the battery pack 90, are collectively depicted surrounded by a long-dash short-dash line. The battery cells 91 store electric power to be supplied to the first motor-generator 13 and the second motor-generator 50. The first motor-generator 13 and the second motor-generator 50 function as motors MG that are power sources of the electric vehicle 10. That is, the multiple battery cells 91 store electric power to be supplied to the motors MG, which are power sources of the electric vehicle 10.

The electric vehicle 10 is equipped with a first inverter 92 that performs power conversion between the battery cells 91 and the first motor-generator 13. The electric vehicle 10 is equipped with a second inverter 93 that performs power conversion between the battery cells 91 and the second motor-generator 50. The second inverter 93 is provided in an upper portion of a driving device 100, which will be discussed below.

The first motor-generator 13 and the second motor-generator 50 are rotating electrical machines that include at least a driving function for generating mechanical drive power from electrical power, and may further include a generator function for generating electrical power from mechanical drive power. For example, the first motor-generator 13 and the second motor-generator 50 are three-phase synchronous electric machines.

The first motor-generator 13 includes a stator 14, a rotor 15, and a rotary shaft 16. The stator 14 is fixed to the electric vehicle 10 so as to be non-rotatable. The rotor 15 is rotatable relative to the stator 14. The rotary shaft 16 is fixed to the rotor 15. Accordingly, the rotary shaft 16 rotates together with the rotor 15. The rotary shaft 16 extends in a front-rear direction.

The second motor-generator 50 includes a stator 51, a rotor 52, and an output shaft 53. The stator 51 is fixed to the electric vehicle 10 so as to be non-rotatable. For example, the stator 51 is fixed to a housing 70, which will be discussed below. The rotor 52 is rotatable relative to the stator 51. The output shaft 53 is fixed to the rotor 52. Accordingly, the output shaft 53 rotates together with the rotor 52. The output shaft 53 extends in the vehicle width direction. An output gear 54 is fixed to the output shaft 53. Accordingly, the output gear 54 rotates together with the output shaft 53.

The first inverter 92 and the second inverter 93 are, for example, devices in which switching elements and other components are mounted on a plate-shaped circuit board. The first inverter 92 and the second inverter 93 are known power supply circuits that convert direct current to alternating current and convert alternating current to direct current.

The electric vehicle 10 includes a charging port assembly 97 configured to be connected to an external power supply in order to charge the battery cells 91 with electric power supplied from the external power supply. The electric vehicle 10 is a plug-in hybrid electric vehicle.

The charging port assembly 97 is provided with a first charging port 94 and a second charging port 95 as charging inlets for connecting a connector of an external power supply. The first charging port 94 is a charging inlet used for fast charging with a high-voltage DC power supply, such as 50 kW. The second charging port 95 is a charging inlet used for standard charging, which is performed using an AC power supply such as 100 V or 200 V. When the connector of the external power supply is connected to the charging inlet, the electric vehicle 10 is connected to the external power supply.

The first charging port 94 is electrically connected to the battery pack 90. A DC power supply is connected to the first charging port 94. The DC power input from the DC power supply connected to the first charging port 94 is supplied to the battery cells 91.

The second charging port 95 is electrically connected to the vehicle on-board charger 96. The vehicle on-board charger 96 is electrically connected to the battery pack 90. The vehicle on-board charger 96 converts AC power input from an AC power supply connected to the second charging port 95 into DC power, and then delivers the DC power to the battery cells 91 to charge the battery cells 91.

The electric vehicle 10 includes a cooling device 98. The cooling device 98 and the second inverter 93 are connected to each other by a first pipe 111. The cooling device 98 and the battery pack 90 are connected to each other by a second pipe 112.

Coolant flows through the first pipe 111 and the second pipe 112. Antifreeze may flow through the first pipe 111 and the second pipe 112. The cooling device 98 cools the coolant flowing through the first pipe 111 and the second pipe 112 by heat exchange. The second inverter 93 is cooled by heat exchange with the coolant flowing through the first pipe 111. The battery cells 91 are cooled by heat exchange with the coolant flowing through the second pipe 112. Accordingly, the cooling device 98 is configured to cool the battery cells 91 accommodated in the battery pack 90 and the second inverter 93.

### Drivetrain of the Electric Vehicle 10

The crankshaft 12 of the engine 11 is connected to a front portion of the rotary shaft 16 of the first motor-generator 13 in the vehicle front-rear direction via a clutch mechanism 17 surrounded by a long-dash double-short-dash line.

The clutch mechanism 17 adjusts the torque transmitted between the crankshaft 12 and the rotary shaft 16 of the first motor-generator 13. When the clutch mechanism 17 is in an engaged state, the crankshaft 12 and the rotary shaft 16 of the first motor-generator 13 are coupled to each other. In contrast, when the clutch mechanism 17 is in a disengaged state, the crankshaft 12 and the rotary shaft 16 of the first motor-generator 13 are decoupled.

A rear portion of the rotary shaft 16 of the first motor-generator 13 is connected to an input shaft of a transmission device 18. The transmission device 18 has a known configuration. An output shaft of the transmission device 18 is connected to an input shaft of a transfer case 19.

The transfer case 19 is a known front-and-rear wheel power distribution device. The transfer case 19 distributes all the rotational drive power of the engine 11 or the first motor-generator 13 only to the rear wheels 67, or distributes the rotational drive power of the engine 11 or the first motor-generator 13 to the front wheels 28 and the rear wheels 67.

### Power Transmission Path Between the Transfer Case 19 and the Front Wheels 28

The electric vehicle 10 includes a front propeller shaft 20, a front differential 21, and two front drive shafts 27 that are arranged in that order from the transfer case 19 in the power transmission path between the transfer case 19 and the front wheels 28. These components have known configurations.

The front propeller shaft 20 is a rotating member that transmits the rotational drive power of the engine 11 or the first motor-generator 13 to the front wheels 28. The transfer case 19 includes, for example, a clutch mechanism that adjusts the torque transmitted between the transfer case 19 and the front propeller shaft 20. When the clutch mechanism is in a disengaged state, the electric vehicle 10 is enabled for two-wheel-drive operation. When the clutch mechanism is in an engaged state, the electric vehicle 10 is enabled for four-wheel-drive operation.

The front differential 21 includes a front differential ring gear 22 and a front differential case 23. The front differential ring gear 22 is provided on the outer periphery of the front differential case 23. The front differential ring gear 22 meshes with a pinion gear provided at a front end of the front drive shaft 27. A front differential pinion shaft 24, two front differential pinion gears 25, and two front differential side gears 26 are located in the internal space of the front differential case 23. The two front differential pinion gears 25 and the two front differential side gears 26 are, for example, bevel gears.

The front differential pinion shaft 24 is fixed inside the front differential case 23. The front differential pinion shaft 24 extends through the two front differential pinion gears 25. Each of the front differential pinion gears 25 meshes with both of the front differential side gears 26. The right front differential side gear 26 is connected to a right front drive shaft 27. The left front differential side gear 26 is connected to the left front drive shaft 27.

The right front drive shaft 27 is a rotating member that couples the right front differential side gear 26 to the right front wheel 28. The left front drive shaft 27 is a rotating member that couples the left front differential side gear 26 to the left front wheel 28.

### Power Transmission Path Between the Transfer Case 19 and the Rear Wheels 67

The electric vehicle 10 includes the rear propeller shaft 30, the driving device 100, and two rear drive shafts 66 disposed in that order from the transfer case 19 in the power transmission path between the transfer case 19 and the rear wheels 67.

The rear propeller shaft 30 transmits the rotational drive power output from the engine 11 rearward. The hypoid pinion 31 is provided at the rear end of the rear propeller shaft 30. The hypoid pinion 31 is fixed to the rear propeller shaft 30 so as to be non-rotatable relative thereto. The hypoid pinion 31 is a truncated cone-shaped gear.

The driving device 100 includes a rear portion of the rear propeller shaft 30, the hypoid pinion 31, the speed reduction mechanism 40, and the second motor-generator 50, which are accommodated in the housing 70 fixed to the vehicle body. The driving device 100 accommodates the rear differential 60. The rear differential 60 is a differential device. The rear differential 60 includes a rear differential ring gear 61 and a rear differential case 62. The rear differential ring gear 61 is provided on the outer periphery of the rear differential case 62.

The speed reduction mechanism 40 transmits the rotational drive power output from the second motor-generator 50 and the rotational drive power transmitted from the rear propeller shaft 30 to the rear differential 60. In other words, the second motor-generator 50 applies drive power to the two rear drive shafts 66 via the rear differential 60. The rear differential 60 splits the drive power transmitted from the rear propeller shaft 30 between the two rear drive shafts 66.

The driving device 100 includes the second motor-generator 50, the speed reduction mechanism 40, the rear differential 60, and the second inverter 93. In other words, the driving device 100 is a unit including a motor MG, the speed reduction mechanism 40, a differential device, and an inverter.

The speed reduction mechanism 40 includes a rotary shaft 44 extending in the vehicle width direction, a first reduction gear 41, a second reduction gear 42, and a third reduction gear 43. The first reduction gear 41, the second reduction gear 42, and the third reduction gear 43 are fixed to the rotary shaft 44 so as to be non-rotatable relative thereto. The third reduction gear 43 is disposed between the first reduction gear 41 and the second reduction gear 42.

The first reduction gear 41 is a hypoid gear that meshes with the hypoid pinion 31 provided at the rear end of the rear propeller shaft 30. The first reduction gear 41 is a truncated cone-shaped gear. The second reduction gear 42 meshes with the output gear 54, fixed to the output shaft 53 of the second motor-generator 50. The third reduction gear 43 meshes with the rear differential ring gear 61.

In other words, the rear differential ring gear 61 receives drive power from the rear propeller shaft 30 and the second motor-generator 50.

Since the first reduction gear 41 is fixed to the rotary shaft 44, rotation of the rear propeller shaft 30 is transmitted to the rotary shaft 44 via the first reduction gear 41. Since the second reduction gear 42 is fixed to the rotary shaft 44, rotation of the output shaft 53 is transmitted to the rotary shaft 44 via the second reduction gear 42. Since the third reduction gear 43 is fixed to the rotary shaft 44, rotation of the rotary shaft 44 is transmitted to the rear differential ring gear 61. That is, since the third reduction gear 43 is fixed to the rotary shaft 44, rotation of the rotary shaft 44 is transmitted to the differential device.

A rear differential pinion shaft 63, two rear differential pinion gears 64, and two rear differential side gears 65 are accommodated in the internal space of the rear differential case 62. The two rear differential pinion gears 64 and the two rear differential side gears 65 are, for example, bevel gears.

The rear differential pinion shaft 63 is fixed inside the rear differential case 62. The rear differential pinion shaft 63 extends through the two rear differential pinion gears 64. Each of the rear differential pinion gears 64 meshes with both of the rear differential side gears 65. The right rear differential side gear 65 is connected to the right rear drive shaft 66. The left rear differential side gear 65 is connected to the left rear drive shaft 66.

The right rear drive shaft 66 is a rotating member that couples the right rear differential side gear 65 to the right rear wheel 67. The left rear drive shaft 66 is a rotating member that couples the left rear differential side gear 65 to the left rear wheel 67.

### Configuration of the Driving Device 100

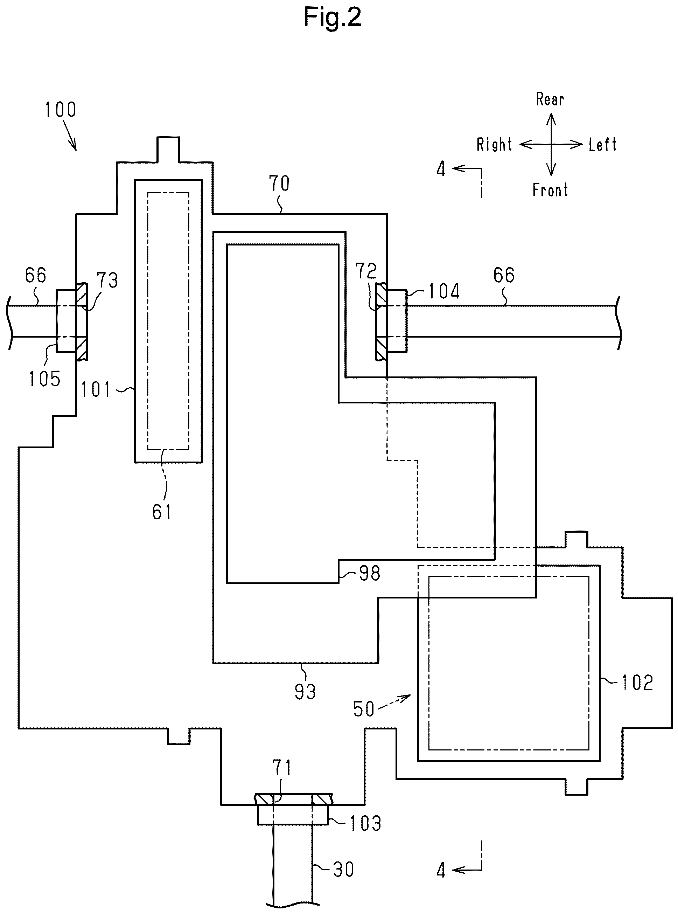

Fig. 2 is a diagram schematically showing a vehicle on-board device mounting structure, in which the driving device 100 is viewed from above.

As shown in Fig. 2, the housing 70 of the driving device 100 has a through-hole 71 in the front surface. The rear propeller shaft 30 is inserted into the through-hole 71. An oil seal 103 provides sealing between the rear propeller shaft 30 and the through-hole 71.

The housing 70 has a through-hole 72 in the left surface thereof. The left rear drive shaft 66 is inserted through the through-hole 72. An oil seal 104 provides sealing between the left rear drive shaft 66 and the through-hole 72.

The housing 70 has a through-hole 73 in the right surface thereof. The right rear drive shaft 66 is inserted through the through-hole 73. An oil seal 105 provides sealing between the right rear drive shaft 66 and the through-hole 73.

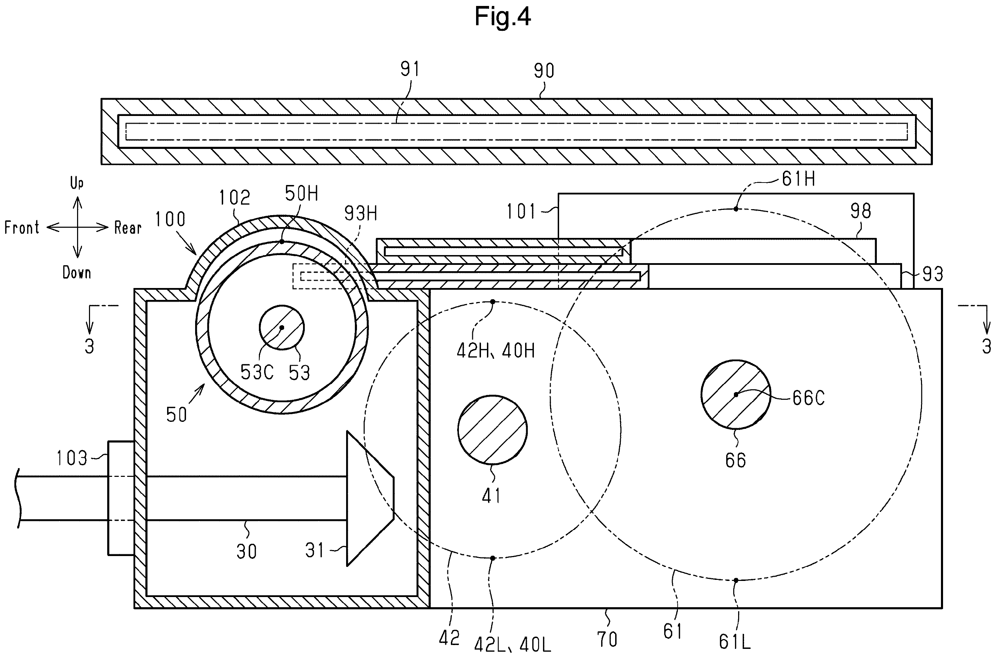

Fig. 4 is a cross-sectional view taken along line 4-4 of Fig. 2. Fig. 4 schematically shows the internal structure of the driving device 100, the cooling device 98, and the battery pack 90 as viewed from the left side.

As shown in Fig. 4, in the driving device 100, the second inverter 93 is disposed above the speed reduction mechanism 40 and the rear drive shaft 66. The cooling device 98 is disposed above the second inverter 93. The battery pack 90 is disposed above the driving device 100.

As shown in Figs. 2 and 4, the driving device 100 includes a first portion 101 and a second portion 102. The first portion 101 and the second portion 102 protrude upward. The rear differential ring gear 61 is accommodated in the first portion 101. The second motor-generator 50 is accommodated in the second portion 102.

As shown in Fig. 2, the second inverter 93 and the first portion 101 do not overlap with each other when viewed in the up-down direction. In other words, the second inverter 93 and the rear differential ring gear 61 do not overlap with each other when viewed in the up-down direction.

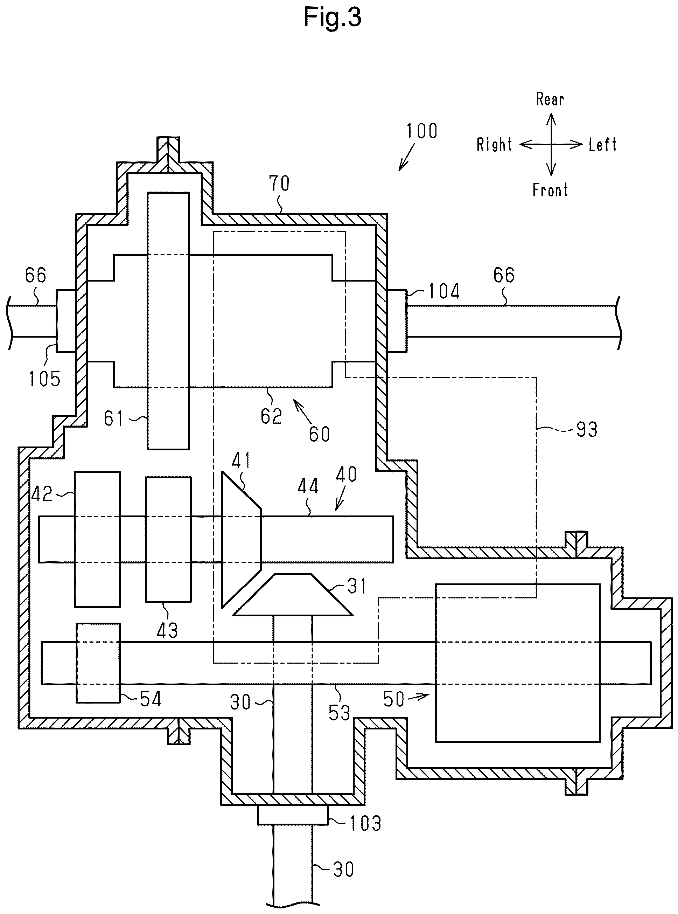

Fig. 3 is a cross-sectional view taken along line 3-3 of Fig. 4. Fig. 3 schematically shows the vehicle on-board device mounting structure inside the driving device 100. Fig. 3 shows a cross section of the housing 70. The components accommodated in the housing 70 are indicated by solid lines. In Fig. 3, the position of the second inverter 93 located above the housing 70 is indicated by a long-dash double-short-dash line.

As shown in Fig. 3, the second inverter 93 is disposed above the rear differential 60. The second inverter 93 and the rear differential case 62 overlap with each other when viewed in the up-down direction.

The second inverter 93 is disposed above the first reduction gear 41 and the rotary shaft 44. That is, the second inverter 93 is disposed above the speed reduction mechanism 40. The second inverter 93 overlaps with the first reduction gear 41 and the rotary shaft 44 when viewed in the up-down direction. That is, the second inverter 93 and the speed reduction mechanism 40 overlap with each other when viewed in the up-down direction.

The second inverter 93 is disposed above the output shaft 53 of the second motor-generator 50. The output shaft 53 is a power transmission component that transmits rotational drive power of the second motor-generator 50 to the rear differential 60.

When viewed in the up-down direction, the second inverter 93 and the output shaft 53 overlap with each other. Specifically, when viewed in the up-down direction, the second inverter 93 and the power transmission component that transmits rotational drive power of the second motor-generator 50 to the rear differential 60 overlap with each other.

The second motor-generator 50, the speed reduction mechanism 40, and the rear differential 60 are disposed in the order of the second motor-generator 50, the speed reduction mechanism 40, and the rear differential 60 from the front.

The second reduction gear 42 has a larger diameter than the output gear 54. The rear differential ring gear 61 has a larger diameter than the third reduction gear 43. Accordingly, the speed reduction mechanism 40 is configured such that the rotational speed of the rear differential ring gear 61 is lower than the rotational speed of the output gear 54.

As shown in Fig. 4, the output shaft 53 of the second motor-generator 50 is disposed above the rear propeller shaft 30.

As shown in Fig. 4, the second inverter 93 and the rear differential ring gear 61 overlap with each other when viewed in the axial direction of the rear drive shaft 66. The axial view of the rear drive shaft 66 is a view along a drive-shaft axis. Thus, the second inverter 93 and the rear differential ring gear 61 overlap with each other in the view along the drive-shaft axis.

As shown in Fig. 4, the second inverter 93 and the second motor-generator 50 overlap with each other when viewed in the direction of the rotation axis of the second motor-generator 50. The view along the rotation axis of the second motor-generator 50 is the view along the rotation axis of the motor MG. Thus, the second inverter 93 and the second motor-generator 50 overlap with each other when viewed in the direction of the rotation axis of the motor MG.

As shown in Fig. 4, an uppermost portion 50H of the second motor-generator 50 is located above the output shaft 53.

As shown in Fig. 3, when viewed in the up-down direction, the second inverter 93 and the second motor-generator 50 do not overlap with each other at the uppermost portion 50H. Accordingly, the second inverter 93 and the uppermost portion 50H of the second motor-generator 50 do not overlap with each other when viewed in the up-down direction.

As shown in Fig. 3, the second reduction gear 42 has the largest diameter among the first reduction gear 41, the second reduction gear 42, and the third reduction gear 43. Therefore, an uppermost portion 42H of the second reduction gear 42 shown in Fig. 4 is an uppermost portion 40H of the speed reduction mechanism 40. A lowermost portion 42L of the second reduction gear 42 is a lowermost portion 40L of the speed reduction mechanism 40.

As shown in Fig. 4, in the side view, the uppermost portion 42H of the second reduction gear 42 is located lower than an uppermost portion 61H of the rear differential ring gear 61. That is, in the side view, the uppermost portion 40H of the speed reduction mechanism 40 is located lower than the uppermost portion 61H of the rear differential ring gear 61.

In the side view, the lowermost portion 42L of the second reduction gear 42 is located higher than a lowermost portion 61L of the rear differential ring gear 61. That is, in the side view, the lowermost portion 40L of the speed reduction mechanism 40 is located higher than the lowermost portion 61L of the rear differential ring gear 61.

When viewed in the horizontal direction, an uppermost portion 93H of the second inverter 93 is located lower than the uppermost portion 61H of the rear differential ring gear 61. When viewed in the horizontal direction, the uppermost portion 93H of the second inverter 93 is located lower than the uppermost portion 50H of the second motor-generator 50.

### Operation of the Present Embodiment

As shown in Fig. 3, the rear differential ring gear 61 is provided on the outer periphery of the rear differential case 62. Accordingly, the vertical dimension of the rear differential ring gear 61 is greater than the vertical dimension of the rear differential case 62. In the driving device 100, when viewed in the up-down direction, the second inverter 93 and the rear differential ring gear 61 do not overlap with each other, and the second inverter 93 and the rear differential case 62 overlap with each other. Thus, as shown in Fig. 4, the second inverter 93 is disposed at a height at which the second inverter 93 and the rear differential ring gear 61 overlap with each other when viewed in the axial direction of the rear drive shaft 66. In the vehicle on-board device mounting structure described above, the vertical dimension of the driving device 100 is reduced as compared with a structure in which the second inverter 93 and the rear differential ring gear 61 do not overlap with each other when viewed in the axial direction of the rear drive shaft 66.

### Advantages of the Present Embodiment

(1) The vehicle on-board device mounting structure described above reduces the vertical dimension of the driving device 100, which is a unit including the second motor-generator 50, the rear differential 60, and the second inverter 93. Accordingly, the installability of the vehicle on-board device in the vehicle is improved.
(2) As shown in Fig. 3, the output shaft 53 is disposed above the rear propeller shaft 30. The output shaft 53 is a power transmission component that transmits rotational drive power of the second motor-generator 50 to the rear differential 60.

As shown in Fig. 4, the second inverter 93 overlaps with the second motor-generator 50 when viewed in the direction of the rotation axis of the second motor-generator 50. In contrast, as shown in Fig. 3, the second inverter 93 does not overlap with the uppermost portion 50H of the second motor-generator 50 when viewed in the up-down direction. Further, when viewed in the up-down direction, the second inverter 93 overlaps with the output shaft 53, which is a power transmission component.

When viewed in the up-down direction, the second inverter 93 is disposed so as to overlap with the rear differential case 62 and the output shaft 53, which is a power transmission path. According to the above-described vehicle on-board device mounting structure, the second inverter 93 is disposed so as to avoid a position where the vertical dimension of the second motor-generator 50 is maximized.

As shown in Fig. 4, in the driving device 100, the second inverter 93 is disposed at a height at which the second inverter 93 and the second motor-generator 50 overlap with each other when viewed in the direction of the rotation axis of the second motor-generator 50. Accordingly, the vehicle on-board device mounting structure described above reduces the vertical dimension of the driving device 100 as compared with a structure in which the second inverter 93 and the second motor-generator 50 do not overlap with each other when viewed in the direction of the rotation axis of the second motor-generator 50. The vehicle on-board device mounting structure described above also readily reduces the vertical dimension of the driving device 100, which includes the second motor-generator 50, the rear differential 60, and the second inverter 93. Accordingly, the installability of the vehicle on-board device in the vehicle is improved.

(3) The electric vehicle 10 includes the speed reduction mechanism 40. The speed reduction mechanism 40 transmits the rotational drive power output from the second motor-generator 50 and the rotational drive power transmitted from the rear propeller shaft 30 to the rear differential 60. As shown in Fig. 3, the second motor-generator 50, the speed reduction mechanism 40, and the rear differential 60 are disposed in the order of the second motor-generator 50, the speed reduction mechanism 40, and the rear differential 60 from the front.

As shown in Fig. 4, in the side view, the uppermost portion 40H of the speed reduction mechanism 40 is located lower than the uppermost portion 61H of the rear differential ring gear 61. The lowermost portion 40L of the speed reduction mechanism 40 is located higher than the lowermost portion 61L of the rear differential ring gear 61. As shown in Fig. 3, the second inverter 93 is disposed so as to overlap with the speed reduction mechanism 40 when viewed in the up-down direction. That is, the second inverter 93 is disposed in a space above the speed reduction mechanism 40, which has a smaller vertical dimension than the rear differential ring gear 61. The above-described vehicle on-board device mounting structure readily reduces the vertical dimension of the driving device 100. Accordingly, the installability of the vehicle on-board device in the vehicle is improved.

(4) As shown in Fig. 4, when viewed in the horizontal direction, an uppermost portion 93H of the second inverter 93 is located lower than the uppermost portion 61H of the rear differential ring gear 61. Therefore, the driving device 100 has a smaller vertical dimension than a comparative unit in which the heights of the driving device 100 and the uppermost portion 61H of the rear differential ring gear 61 are the same, and the uppermost portion 93H of the second inverter 93 is higher than the uppermost portion 61H of the rear differential ring gear 61. The above-described vehicle on-board device mounting structure thus reduces the vertical dimension of the driving device 100. Accordingly, the installability of the vehicle on-board device in the vehicle is improved.

(5) As shown in Fig. 4, when viewed in the horizontal direction, the uppermost portion 93H of the second inverter 93 is located lower than the uppermost portion 50H of the second motor-generator 50. Therefore, the driving device 100 has a smaller vertical dimension than a comparative unit in which the driving device 100 and the uppermost portion 50H of the second motor-generator 50 are the same, and the uppermost portion 93H of the second inverter 93 is higher than the uppermost portion 50H of the second motor-generator 50. The above-described vehicle on-board device mounting structure thus reduces the vertical dimension of the driving device 100. Accordingly, the installability of the vehicle on-board device in the vehicle is improved.

(6) As shown in Fig. 4, the battery pack 90 is disposed above the second inverter 93. The above-described vehicle on-board device mounting structure reduces the vertical dimension of the driving device 100. This configuration allows the vehicle interior space above the driving device 100 to be utilized to dispose the battery pack 90.

(7) The electric vehicle 10 includes the cooling device 98, which cools the second inverter 93.

As shown in Fig. 4, the cooling device 98 is disposed above the second inverter 93. According to the vehicle on-board device mounting structure described above, the cooling device 98, which cools the second inverter 93, is disposed in the vicinity of the second inverter 93. Accordingly, the first pipe 111, which connects the second inverter 93 to the cooling device 98, can be kept short. Thus, according to the vehicle on-board device mounting structure described above, the second inverter 93 is efficiently cooled by the cooling device 98.

(8) The cooling device 98 is configured to also cool the battery cells 91.

As shown in Fig. 4, the cooling device 98 is disposed above the second inverter 93. The battery pack 90 is disposed above the cooling device 98. According to the vehicle on-board device mounting structure described above, the cooling device 98, which cools the second inverter 93 and the battery cells 91, is disposed in the vicinity of the second inverter 93 and the battery pack 90. Accordingly, the first pipe 111, which connects the second inverter 93 to the cooling device 98, and the second pipe 112, which connects the battery pack 90 to the cooling device 98, can be kept short. Thus, according to the vehicle on-board device mounting structure described above, the second inverter 93 and the battery cells 91 are efficiently cooled by the cooling device 98.

### Modifications

The above-described embodiment may be modified as follows. The above-described embodiment and the following modifications of the above-described embodiment can be combined as long as the combined modifications remain technically consistent with each other.

When all of the following requirements (1), (2), and (3) are satisfied, the power transmission component that transmits the rotational drive power of the second motor-generator 50 to the rear differential 60 may be disposed below the rear propeller shaft 30. For example, the output shaft 53 of the second motor-generator 50 may be disposed below the rear propeller shaft 30.

Requirement (1): The second inverter 93 and the rear differential ring gear 61 overlap with each other when viewed in the axial direction of the rear drive shaft 66.

Requirement (2): The second inverter 93 and the rear differential ring gear 61 do not overlap with each other when viewed in the up-down direction.

Requirement (3): The second inverter 93 and the rear differential case 62 overlap with each other when viewed in the up-down direction.

When all of the above requirements (1), (2), and (3) are satisfied, the second inverter 93 and the second motor-generator 50 do not necessarily need to overlap with each other when viewed in the direction of the rotation axis of the second motor-generator 50.

When all of the above requirements (1), (2), and (3) are satisfied, the second inverter 93 and the output shaft 53 of the second motor-generator 50 do not necessarily need to overlap with each other when viewed in the up-down direction.

When all of the above requirements (1), (2), and (3) are satisfied, the second inverter 93 and the uppermost portion 50H of the second motor-generator 50 do not necessarily need to overlap with each other when viewed in the up-down direction.

When all of the above requirements (1), (2), and (3) are satisfied, the second inverter 93 and the speed reduction mechanism 40 do not necessarily need to overlap with each other when viewed in the up-down direction.

When all of the requirements (1), (2), and (3) are satisfied, the second inverter 93 may be disposed below the rear differential 60.

As long as all of the requirements (1), (2), and (3) are satisfied and the second inverter 93 is disposed above the rear differential 60, the uppermost portion 93H of the second inverter 93 may be located higher than the uppermost portion 61H of the rear differential ring gear 61 when viewed in the horizontal direction.

As long as all of the requirements (1), (2), and (3) are satisfied and the second inverter 93 is disposed above the rear differential 60, the uppermost portion 93H of the second inverter 93 may be located higher than the uppermost portion 50H of the second motor-generator 50 when viewed in the horizontal direction.

The cooling device 98 does not necessarily need to be disposed above the second inverter 93. For example, the cooling device 98 may be disposed below the driving device 100.

The battery pack 90 does not necessarily need to be disposed above the cooling device 98. For example, the battery pack 90 may be disposed below the cooling device 98.

The battery pack 90 does not necessarily need to be disposed above the second inverter 93. For example, the battery pack 90 may be disposed below the second inverter 93.

The battery cells 91 and the second inverter 93 may be cooled by two different cooling devices.

The second motor-generator 50, the speed reduction mechanism 40, and the rear differential 60 do not necessarily need to be disposed in the order of the second motor-generator 50, the speed reduction mechanism 40, and the rear differential 60 from the front. For example, the second motor-generator 50, the speed reduction mechanism 40, and the rear differential 60 may be disposed in the order of the rear differential 60, the speed reduction mechanism 40, and the second motor-generator 50 from the front.

Various changes in form and details may be made to the examples above without departing from the spirit and scope of the claims and their equivalents. The examples are for the sake of description only, and not for purposes of limitation. Descriptions of features in each example are to be considered as being applicable to similar features or aspects in other examples. Suitable results may be achieved if sequences are performed in a different order, and/or if components in a described system, architecture, device, or circuit are combined differently, and/or replaced or supplemented by other components or their equivalents. The scope of the disclosure is not defined by the detailed description, but by the claims and their equivalents. All variations within the scope of the claims and their equivalents are included in the disclosure.

## Claims

1. A vehicle on-board device mounting structure for a vehicle (10), wherein the vehicle (10) includes:
a differential device (60) for splitting drive power transmitted from a propeller shaft (30) between two drive shafts (66);
a motor (50, MG) for applying the drive power to the two drive shafts (66) via the differential device (60); and
an inverter (93) for performing power conversion between a battery cell (91) accommodated in a battery pack (90) and the motor (50, MG),
the differential device (60) includes:
a differential case (62) for accommodating two side gears (65) respectively coupled to the two drive shafts (66), and a differential pinion (63) that meshes with both of the two side gears (65); and
a ring gear (61) provided on an outer periphery of the differential case (62) for receiving the drive power transmitted from the propeller shaft (30) and the motor (50, MG), and
the vehicle on-board device mounting structure is configured such that
the inverter (93) and the ring gear (61) overlap with each other when viewed in an axial direction of the drive shaft (66),
the inverter (93) and the ring gear (61) do not overlap with each other when viewed in an up-down direction of the vehicle (10), and
the inverter (93) and the differential case (62) overlap with each other when viewed in the up-down direction.

2. The vehicle on-board device mounting structure according to claim 1, wherein
a power transmission component (53) for transmitting rotational drive power of the motor (50) to the differential device (60) is disposed above the propeller shaft (30),
the inverter (93) and the motor (50) overlap with each other when viewed in a direction of a rotation axis of the motor (50),
the inverter (93) and the power transmission component (53) overlap with each other when viewed in the up-down direction, and
the inverter (93) and an uppermost portion (50H) of the motor (50) do not overlap with each other when viewed in the up-down direction.

3. The vehicle on-board device mounting structure according to claim 1 or 2, further comprising a speed reduction mechanism (40) for transmitting the rotational drive power output from the motor (50) and the rotational drive power transmitted from the propeller shaft (30) to the differential device (60), wherein
the motor (50), the speed reduction mechanism (40), and the differential device (60) are arranged in an order of the motor (50), the speed reduction mechanism (40), and the differential device (60) from a front side,
in a side view of the vehicle (10), an uppermost portion of the speed reduction mechanism (40) is located lower than an uppermost portion (40H) of the ring gear,
a lowermost portion of the speed reduction mechanism (40) is located higher than a lowermost portion (61L) of the ring gear (61), and
the inverter (93) is disposed so as to overlap with the speed reduction mechanism (40) when viewed in the up-down direction.

4. The vehicle on-board device mounting structure according to any one of claims 1 to 3, wherein the inverter (93) is disposed above the differential device (60) when viewed in a horizontal direction of the vehicle (10).

5. The vehicle on-board device mounting structure according to any one of claims 1 to 4, wherein an uppermost portion (93H) of the inverter (93) is located lower than an uppermost portion (61H) of the ring gear (61) when viewed in a horizontal direction.

6. The vehicle on-board device mounting structure according to any one of claims 1 to 5, wherein an uppermost portion (93H) of the inverter (93) is located lower than an uppermost portion (50H) of the motor (50) when viewed in a horizontal direction.

7. The vehicle on-board device mounting structure according to any one of claims 1 to 6, wherein the battery pack (90) is disposed above the inverter (93).

8. The vehicle on-board device mounting structure according to any one of claims 1 to 7, comprising a cooling device (98) that cools the inverter (93),
wherein the cooling device (98) is disposed above the inverter (93).

9. The vehicle on-board device mounting structure according to claim 8, wherein
the cooling device (98) is configured to cool the battery cell (91),
the cooling device (98) is disposed above the inverter (93), and
the battery pack (90) is disposed above the cooling device (98).
